# EUROPÄISCHE PATENTSCHRIFT

(11) **EP 2 864 267 B1**
(45) Veröffentlichungstag und Bekanntmachung des Hinweises auf die Patenterteilung: **27.12.2017**
(21) Anmeldenummer: 13732868.8
(22) Anmeldetag: 19.06.2013
(51) Int. Cl.: C03C 17/34

(54) **THERMOCHROMES GLAS MIT BESCHICHTUNG VON FARBNEUTRALEM VANADIUMDIOXID**
THERMOCHROMIC GLASS COMPRISING A COATING OF NEUTRAL-COLOUR VANADIUM DIOXIDE
VERRE THERMOCHROME À REVÊTEMENT DE DIOXYDE DE VANADIUM DE COULEUR NEUTRE

(30) Priorität: 21.06.2012 DE 102012012219
(43) Veröffentlichungstag der Anmeldung: 29.04.2015
(73) Patentinhaber: Justus-Liebig- Universitat Giessen, 35390 Giessen (DE)
(72) Erfinder: MEYER, Bruno, 35440 Großen-Linden (DE); POLITY, Angelika, 61231 Bad Nauheim (DE); DIETRICH, Marc Konstantin, 35390 Giessen (DE)
(74) Vertreter: Stumpf, Peter
(86) Internationale Anmeldenummer: PCT/EP2013/062770
(87) Internationale Veröffentlichungsnummer: WO 2013/189996

(56) Entgegenhaltungen:
- EP-A1- 0 994 081
- WO-A1-2010/038202
- GB-A- 2 114 965
- US-A- 6 110 656
- US-A1- 2002 037 421
- US-A1- 2003 054 177
- US-A1- 2012 107 687
- US-A1- 2013 101 848
- Pragna Kiria ET AL: "Solid State Thermochromic Materials", ADVANCED MATERIALS LETTERS, vol. 1, no. 2, 1 September 2010 (2010-09-01), pages 86-105, XP055332228, IN ISSN: 0976-3961, DOI: 10.5185/amlett.2010.8147

## Beschreibung

Die Erfindung betrifft eine thermochrome Glasbeschichtung bzw. ein Verfahren zur Herstellung derselben. Solche thermochrome Beschichtungen verfügen über einen sich mit der Temperatur ändernden Transmissionsgrad für elektromagnetische Strahlung z.B. IR, VIS, UV und sollen im Gebäudebau als Glasfenster- oder Glasfassadenbeschichtungen verwendet werden, um das Raumklima im Gebäudeinneren zu beeinflussen und Energie zu sparen.

### [Stand der Technik]

In der DE69910322T2 wurde eine Glasbeschichtung aus Vanadiumdioxid VO₂ mit Alkalimetalldotierung beschrieben. Das Vanadiumdioxid weist einen Phasenübergang bei ca. 68°C auf. Oberhalb dieser Temperatur liegt es als metallische Phase vor und reflektiert elektromagnetische Strahlung vor allem im infraroten Spektralbereich (500 bis 2000 nm). Unterhalb dieser Temperatur liegt eine halbleitende Phase vor und lässt Infrarot-Strahlung durch. Das wird als thermochromer Effekt bezeichnet.

Die Phasenübergangstemperatur kann durch Dotierung mit Wolfram reduziert werden. Allerdings verschlechtert sich der Transmissionsgrad für sichtbares Licht, der aber mittels Fluor-Dotierung erhöht werden kann. Allerdings verschlechtern sich die Schalteigenschaften bei einer Dotierung mit Fluor.

Vanadiumdioxid weist eine bronzene Färbung auf. Das ist besonders nachteilig, da diese Färbung als Filter für das sichtbare Licht wirkt. Damit ist die Transmission im sichtbaren Bereich der elektromagnetischen Strahlung erheblich eingeschränkt. Die oben genannte Schrift gibt dafür keine Lösung, da diese Färbung weder durch die Schichtdicke noch durch weitere Schichten verhindert werden kann.

In der DE3347918C2 wird die Reduktion des Vanadiumdioxids zu Vanadiumtrioxid V₂O₃ vorgeschlagen, welches grau ist. Vanadiumtrioxid hat einen Phasenübergang bei 168 K und ist damit nicht für die Anwendung als thermochrome Fensterglasbeschichtung geeignet. Ein geeigneter Phasenübergang liegt im Bereich 300 K bis 373 K vor

In beiden Schriften wird die Vanadiumdioxidschicht durch CVD aufgetragen. Das ist aber bei der gasförmigen Fluordotierung nachteilig, da bei Abscheidetemperaturen von über 600°C ein effektiver Fluoreinbau in das Vanadiumdioxidkristallgitter nicht möglich ist. Andererseits ist bei einer zu geringen Temperatur (< 400°C) nur eine amorphe Schicht Vanadiumdioxid abscheidbar, die nur schlechte Schalteigenschaften zeigt. Daher ist es wichtig, eine kristalline Schicht Vanadiumdioxid zu erzeugen.

Die WO 2010/038202 A1 schlägt eine thermochrome Schicht enthaltend Vanadiumdioxid vor, wobei das Vanadiumdioxid mit Aluminium oder Magnesium als einem ersten Dotierungselement dotiert ist. Das Vanadiumdioxid ist darüber hinaus mit einem zweiten Element dotiert ausgewählt aus der Gruppe W, Mo, Nb und Ta.

Die US 6 110 656 A betrifft kolloidales Vanadiumoxid, was zur Herstellung von antistatischen oder elektrisch leitenden Schichten verwendet werden kann. Die D5 offenbart sowohl ein Verfahren zur Herstellung sowie Zusammensetzungen dieser Schichten, wobei aus interkalierenden kolloidalen Vanadiumoxid-Partikeln und wasserlöslichen Vinylpolymeren Gelschichten gebildet werden. Die Entgegenhaltung lehrt die technischen Eigenschaften dieser Gelschichten und offenbart, dass diese sowohl elektrisch leitfähig als auch antistatisch sein können und zudem eine erhöhte Stabilität aufweisen.

### [Aufgabe]

Aufgabe der vorliegenden Erfindung ist es, die Nachteile des Standes der Technik zu beseitigen bzw. zu umgehen.

### [Lösung der Aufgabe]

Die Aufgabe wird erfindungsgemäß durch eine thermochrome Schicht für Glas, die eine Vanadiumdioxidschicht umfasst und dadurch gekennzeichnet ist, dass die Vanadiumdioxidschicht aus Vanadiumdioxid besteht und eine Dotierung mit den Erdalkalimetallen Calcium, Barium, Strontium einzeln oder in Kombination umfasst.

Die Konzentration eines Erdalkalimetalls der Gruppe, bestehend aus Ba, Sr und Ca, vorzugsweise Calcium, liegt im Bereich von 0,01 bis 15 Atomprozent, vorzugsweise 1,0 bis 10,0 Atomprozent.

Bevorzugt wird diese Vanadiumdioxidschicht mit Wolfram und/oder Fluor dotiert. Die Entfärbung des Vanadiumdioxids wird erfindungsgemäß durch eine Dotierung mit Erdalkalielementen wie z.B. Calcium (Ca), Strontium (Sr), Barium (Ba) einzeln oder in Kombination erreicht. Diese Dotierung der Vanadiumdioxidschicht mit den Erdalkalielementen erfolgt direkt in das Vanadiumdioxid oder zusätzlich zur Dotierung mit Wolfram, Fluor oder anderen Elementen (z.B. Alkalimetalle - 1. HG: Li, Na, K, Rb, Cs, Elemente der 3.,4.,5. HG - z.B. B, Al, Ga, In, Si, Ge, Sn, Pb, P, As, Sb, Bi und Übergangsmetalle, außer Mg, Ca, Sr, Ba,).

Bei der Kodotierung mit Wolfram und Calcium hat sich gezeigt, dass eine Synergie beider oben beschriebenen Effekte erzielt wird. Das hat zur Folge, dass zum einen aufgrund des Wolframeinbaus die Schalttemperatur Tc in den Bereich der Raumtemperatur herabgesetzt wird. Zum anderen führt der Einbau von Calcium bei den so hergestellten Beschichtungen zu einer Erhöhung des Lichttransmissionsgrades, insbesondere im sichtbaren Spektralbereich, wobei die Lichtabsorptionskante eine Blauverschiebung erfährt. Das optische Erscheinungsbild einer solchen Beschichtung verändert sich mit steigender Calciumkonzentration von einem bronzenen zu einem neutralen Farbeindruck.

Die Wolframkonzentration liegt bei den thermochromen Beschichtungen entsprechend der vorliegenden Erfindung im Bereich von 0,01 bis 3,0 Atomprozent, vorzugsweise 0,4 bis 2,6 Atomprozent.

Die Fluorkonzentration liegt im Bereich von 0,01 bis 2,0 Atomprozent, vorzugsweise 0,5 bis 1,5 Atomprozent.

Die Vanadiumdioxidschicht weist eine Dicke von 10 bis 300 nm, vorzugsweise im Bereich von 40 bis 100 nm, auf.

Zwischen das Glas und die Vanadiumdioxidschicht wird bevorzugt eine Kristallkeimschicht eingefügt, die die Kristallisation der Vanadiumdioxidschicht auch bei niedrigen Temperaturen (< 400°C) fördert. Hierzu verwendet man Titandioxidoder Siliziumoxid, bevorzugt Titandioxid.
Die Kristallkeimschicht (auch Zwischenschicht) weist eine Dicke von 5 bis 200 nm, vorzugsweise im Bereich von 10 bis 70 nm, auf.

Eine Nachoxidation der dotierten Vanadiumdioxidschicht, mit W oder F oder einem Erdalkalimetall der Gruppe, umfassend Ba, Sr, und Ca, oder der kodotierten Vanadiumdioxidschicht, mit W oder F und einem Erdalkalimetall der Gruppe, umfassend Ba, Sr, und Ca, kann durch eine Abdeckungsschicht verhindert werden. So wird eine Abdeckungsschicht aus den Verbindungen Aluminiumoxinitrid, Zinkoxisulfid, Zinkoxid und Zinksulfid einzeln und in Kombination aufgebracht. Diese Abdeckungsschicht dient außerdem als Anti-Reflexionsschicht, wodurch sich der Lichttransmissionsgrad zusätzlich verbessert. Es hat sich gezeigt, dass es vorteilhaft ist, wenn die Abdeckungsschicht eine Dicke von 10 bis 300 nm, bevorzugt 40 bis 100 nm, aufweist.

### Verfahren zur Herstellung der Schicht

Die Vanadiumdioxidschicht wird mit einem Zerstäubungsverfahren (Sputtern) abgeschieden, vorzugsweise mit einem Hochfrequenz- bzw. Radiofrequenz - Kathodenzerstäubungsverfahren oder DC - Kathodenzerstäubungsverfahren. Alternativ ist eine Beschichtung über CVD, andere PVD-Verfahren, Sol-Gel Verfahren und diese auch Plasma-unterstützt erreichbar. Als Quellen werden Targets der Elemente, Elementoxide oder Elementfluoride von Vanadium, Wolfram, Calcium, Strontium, Barium einzeln oder in Kombination verwendet. Damit ist durch Sputtern in einer Argon-Sauerstoff - Atmosphäre der Übertrag der Elemente auf das Glas als Träger durchführbar. Dabei ist das Verhältnis der Massenflüsse der Gase Argon und Sauerstoff zueinander vorzugsweise im Bereich von 5,7 zu 1,4.

Bei zusätzlicher gasförmiger Fluordotierung wird Tetrafluormethan (CF₄) oder Trifluormethan (CHF₃) dem Argon zugesetzt. Dabei ist das Verhältnis der Massenflüsse der Gase Argon, Sauerstoff und CF₄ zueinander vorzugsweise im Bereich von 5,7 zu 1,4 zu 0,3. Ähnliche Verhältnisse gelten beim Zusatz von anderen Fluorierungsmitteln wie CHF₃.
Alternativ dazu werden die fluorierten Elemente z.B. Calciumfluorid, Strontiumfluorid und oder Bariumfluorid als Substrate eingesetzt. Ein Einsatz von fluorierten Elementen und fluorhaltigen Gas ist ebenfalls eine Ausführungsform.

Bei einer Abscheidetemperatur von Raumtemperatur bis 400°C wird das Glas zuerst mit einer Titandioxidschicht als Kristallkeimschicht überzogen und anschließend eine Vanadiumdioxidschicht mit den Dotierungen aufgebracht.

Die dotierte Vanadiumdioxidschicht wird bevorzugt mit einer Abdeckschicht, die bevorzugt als Antireflexschicht ausgebildet ist, überschichtet.

Die thermochrome Schicht wird für Glas (z.B. Fensterglas, Glasrohre, Trinkgläser), Solarzellen (Photovoltaik), Solarkollektoren (Warmwasseraufbereitung) verwendet.

Die erfindungsgemäße Ausführung ist nachfolgend erläutert, wobei die Erfindung alle nachfolgend aufgeführten bevorzugten Ausführungsformen einzeln und in Kombination umfasst.

### [Ausführungsbeispiele]

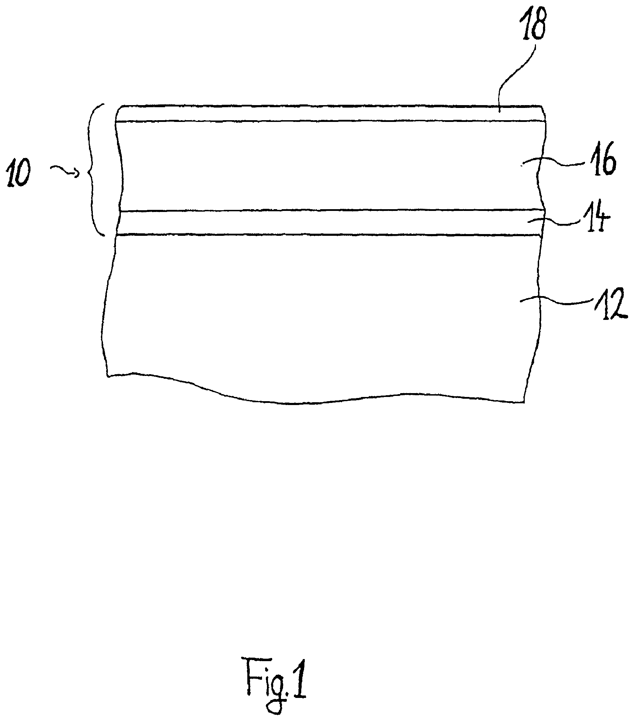

Fig. 1 zeigt gemäß der vorliegenden Erfindung den prinzipiellen Aufbau einer thermochromen Beschichtung 10, wie sie beispielsweise auf eine Fensterglasscheibe 12 aufgebracht werden kann. Dazu wird auf ein Glassubstrat 12 eine Titanoxidschicht 14 mit reaktiver Hochfrequenz- bzw. Radiofrequenz-Kathodenzerstäubung abgeschieden. Die so erzeugte Titanoxidschicht, bildet eine Kristallkeimschicht auf dem Glassubstrat 12.

Die Leistung des Hochfrequenzgenerators beim Sputtern liegt beim Abscheiden der Titanoxidschicht vorzugsweise im Bereich von 100 bis 600 W (entsprechen 1,2 bis 7,4 W/cm²), am meisten bevorzugt bei 300 W (entspricht 3,7 W/cm²). Die Abscheidetemperatur liegt vorzugsweise im Bereich von Raumtemperatur bis 600°C, am meisten bevorzugt bei ca. 300°C.

Anschließend wird von einem Wolfram oder Calcium enthaltenden Vanadium-Target oder Vanadiumoxid-Target mit einer reaktiven Hochfrequenz- bzw. Radiofrequenz-Kathodenzerstäubung eine Vanadiumdioxidschicht auf die Titandioxidschicht aufgetragen. Die Vanadiumdioxidschicht 16 ist die thermochrome Schicht. Die Schicht enthält ca. 3,3% Ca mit 0,2% W und 0,3% F, Rest VO₂. Alternativ enthält die Beschichtung 8,9% Ca mit 0,4% W Rest VO₂. Zusätzlich wurde eine Beschichtung mit 8,9% Ca Rest VO₂ hergestellt. Zusätzlich wurde eine Beschichtung mit ca. 9% Sr Rest VO₂ hergestellt. Zusätzlich wurde eine Beschichtung mit ca. 9% Ba Rest VO₂ hergestellt.

Die Leistung des Hochfrequenzgenerators beim Sputtern liegt beim Abscheiden der dotierten Vanadiumdioxidschicht vorzugsweise im Bereich von 100 bis 600 W (entsprechen 1,2 bis 7,4 W/cm²), am meisten bevorzugt bei 300 W (entspricht 3,7 W/cm²), während die Abscheidetemperatur vorzugsweise im Bereich von 100 bis 600°C, am meisten bevorzugt bei ca. 400°C, liegt.

Eine mit Fluor und einem Erdalkalimetall der Gruppe, umfassend Ba, Sr, und Ca, kodotierte Vanadiumdioxidschicht bzw. mit Wolfram und einem Erdalkalimetall der Gruppe, umfassend Ba, Sr, und Ca, kodotierte Vanadiumdioxidschicht enthält folgende bevorzugte Formeln für die thermochrome Schicht, wobei M das entsprechende Erdalkalimetall bezeichnet:
a)

   V_{1-X-Y} W_{X} M_{Y} O₂
b)

   V_{1-Y} M_{Y} O_{2-Z} F_{Z}

Alternativ wird eine dreifach-dotierte Vanadiumdioxidschicht mit Fluor, Wolfram und einem Erdalkalimetall der Gruppe, umfassend Ba, Sr, und Ca, erzeugt. Die Zusammensetzung lässt sich durch folgende Formel beschreiben, wobei M das Erdalkalimetall bezeichnet:
c)

   V_{1-X-Y} W_{X} M_{Y} O_{2-Z} F_{Z}

Dotierungen mit weiteren Elementen führen zu anderen Formeln und Gewichtsverhältnissen.

Auf der thermochromen dotierten Vanadiumdioxidschicht 16 wird anschließend eine ebenfalls mit Hochfrequenz-Kathodenzerstäubung abgeschiedene Abdeckungsschicht bzw. Abdeckschicht 18 aufgebracht, welche bevorzugt aus Zinksulfid besteht. Weiterhin werden statt Zinksulfid auch Aluminiumoxinitrid, Aluminiumnitrid, Aluminiumoxid, Zinkoxisulfid oder Zinkoxid oder Mischphasen von diesen Verbindungen (inklusive Zinksulfid) eingesetzt. Diese Abdeckungsschicht 18 dient der thermochromen Schicht 16 als Schutz vor Nachoxidation und als Anti-Reflexionsschicht, wodurch vor allem im sichtbaren Spektralbereich der Lichttransmissionsgrad erhöht wird.

Die Leistung des Hochfrequenzgenerators beim Sputtern liegt beim Abscheiden der Zinksulfid-Abdeckungsschicht vorzugsweise im Bereich von 100 bis 600 W (entsprechen 1,2 bis 7,4 W/cm²), am meisten bevorzugt bei 200 W (entspricht 2,5 W/cm²), während die Abscheidetemperatur vorzugsweise im Bereich von Raumtemperatur bis 400°C, am meisten bevorzugt bei Raumtemperatur, liegt.

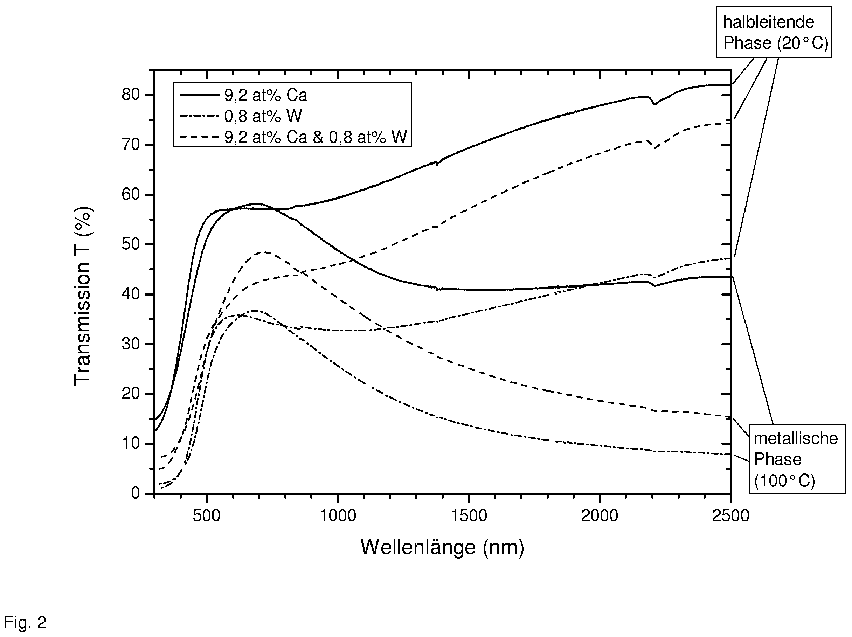

Die Fig. 2 zeigt das wellenlängenabhängige Transmissionsverhalten für eine mit Calcium dotierte bzw. eine mit Wolfram und Calcium kodotierte an einer Hochfrequenz-Kathodenzerstäubungsanlage, auf Glas abgeschiedene Vanadiumdioxidschicht 16, ohne Titandioxidschicht 14 und ohne Anti-Reflexionsdeckschicht. Zusätzlich ist zum Vergleich eine lediglich mit Wolfram dotierte Vanadiumdioxidschicht abgebildet. Die Schichten wurden bei einer Abscheidetemperatur von ca. 600°C (ohne gasförmige Fluor-Dotierung) hergestellt. Zu sehen sind die Niedrigtemperaturphase gemessen bei 20°C und die Hochtemperaturphase bei 100°C der drei Schichten. Die lediglich mit Calcium dotierte Schicht weist hinsichtlich der lediglich mit Wolfram dotierten Schicht für den Bereich von 300 bis 2500 nm durchweg eine deutlich höhere Transmission auf. Des Weiteren zeigt die mit Calcium und Wolfram kodotierte Schicht eine geringere Transmission für den Bereich von 300 bis 2500 nm als die lediglich mit Calcium dotierte Schicht, jedoch höhere Transmission als die lediglich mit Wolfram dotierte Schicht. Insbesondere ist der Transmissionsunterschied zwischen Niedrigtemperatur- und Hochtemperaturphase deutlich größer im Vergleich zu den anderen Schichten.

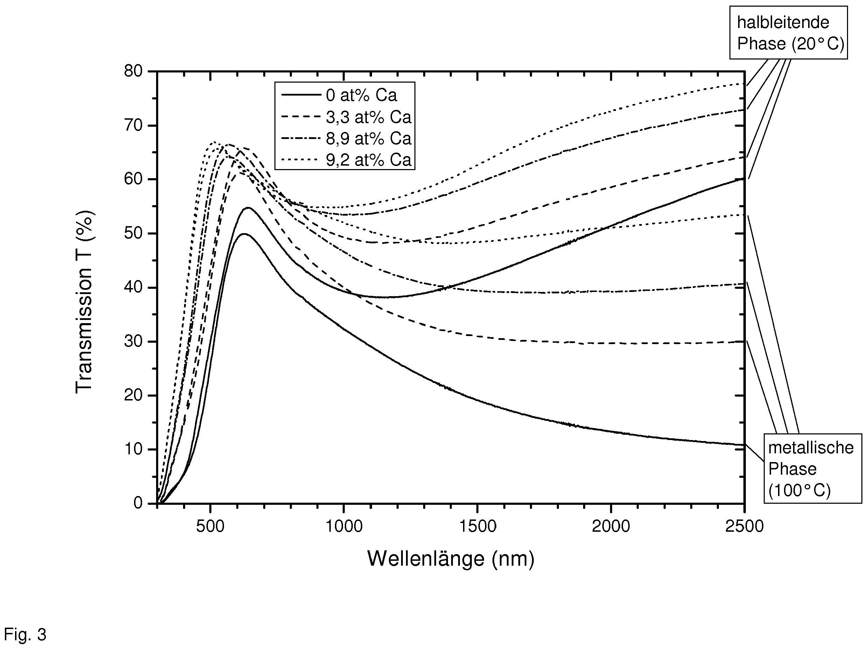

Die Fig. 3 zeigt das wellenlängenabhängige Transmissionsverhalten von mit verschiedenen Calcium-Konzentrationen dotierten an der Hochfrequenz-Kathodenzerstäubungsanlage abgeschiedenen Vanadiumdioxidschichten 16 mit einer 20 nm dicken Titanoxidzwischenschicht 14 aber ohne Anti-Reflexdeckschicht. Die Schichten wurden bei einer Abscheidetemperatur von ca. 400°C hergestellt. Aus dem Vergleich der Kurven erkennt man, dass der Transmissionsgrad für beide Phasen vor allem im Bereich von 1000 bis 2500 nm mit steigender Calcium-Konzentration größer wird. Des Weiteren ist eine Blauverschiebung der Absorptionskante mit steigender Calcium-Konzentration zu sehen, wodurch sich auch der Farbeindruck der Schichten von einer bronzenen zu einer neutralen Färbung verändert.

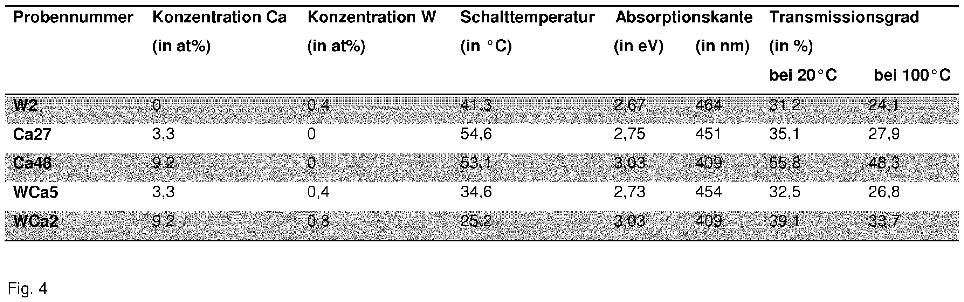

Fig. 4 zeigt eine Tabelle, welche die Schalttemperaturen, die Absorptionskanten (Bandlücke) und die ermittelten Elementkonzentrationen sowie den spektralen Transmissionsgrad der Hoch- (gemessen bei 100°C) und Niedertemperaturphase (gemessen bei 20°C) für unterschiedliche thermochrome Beschichtungen beinhaltet, wobei dieselben Bedingungen für die Schichtherstellung galten, wie bei den gemessenen Schichten in Fig. 2 dargestellt.

Wie in der Tabelle dargestellt, tritt beim Kodotieren mit Wolfram und Calcium ein Synergieeffekt auf, d.h. die kodotierten Schichten weisen eine vor allem durch das Wolfram hervorgerufene Verschiebung der Schalttemperatur zu niedrigeren Temperaturen sowie eine Verschiebung der Absorptionskante zu höheren Energien bzw. zu niedrigeren Wellenlängen durch die Dotierung mit Calcium auf.

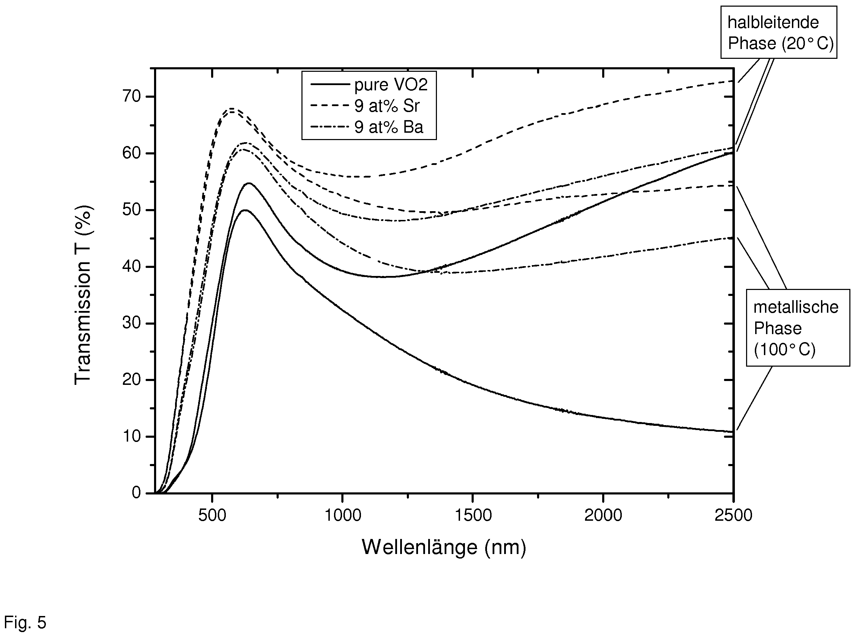

Fig. 5 bildet das wellenlängenabhängige Transmissionsverhalten für eine mit Strontium und eine mit Barium dotierte sowie eine undotierte an der Hochfrequenz-Kathodenzerstäubungsanlage auf Glas abgeschiedene Vanadiumdioxidschicht 16 ohne Titanoxidzwischenschicht 14 und ohne Anti-Reflexdeckschicht ab. Die Schichten wurden bei einer Abscheidetemperatur von ca. 650°C hergestellt. Die ermittelten Barium- bzw. Strontium-Konzentrationen liegen bei ca. 9 Atomprozent.

Im Vergleich zur mit Calcium dotieren Schicht in Fig. 2 zeigen die mit Strontium und mit Barium dotieren Schichten aus Fig. 5 ein ähnliches Schaltverhalten. Die Transmission im Bereich von 300 bis 2500 nm liegt deutlich höher und die Absorptionskante setzt erst bei höheren Energien bzw. niedrigeren Wellenlängen ein als bei der undotierten Vanadiumdioxidschicht in Fig. 5.

Das Erhöhen des Transmissionsgrades, vor allem im blauen Spektralbereich, hat zur Folge, dass das optische Erscheinungsbild der thermochromen Beschichtung gegenüber den aus dem Stand der Technik bekannten lediglich mit Fluor oder Wolfram dotierten Vanadiumdioxidschichten wesentlich verbessert ist und sich durch den gleichzeitigen Wolfram- oder Fluoreinbau die Schalttemperatur in den Bereich der Raumtemperatur verschiebt. Zwar steigt, wie man in Fig. 3 sehen kann, die Transmission der erfindungsgemäßen thermochromen Beschichtung im Vergleich zur lediglich mit Wolfram dotierten Vanadiumdioxidbeschichtung auch in der Hochtemperaturphase an, jedoch bleibt der Transmissionsunterschied zwischen Hoch- und Niedrigtemperaturphase ungefähr gleich bzw. für Probe Ca48 (siehe Fig. 4) steigt er sogar.

Zur Erreichung einer genügend guten Kristallinität des Vanadiumdioxids und damit des thermochromen Effekts ist die dotierte Vanadiumdioxidschicht auf einer Kristallkeimschicht aufzubringen, wobei neben dem Sputtern, PVD oder Sol-Gel-Methoden einsetzbar sind. Bei Sol-Gel-Methoden ist auf eine möglichst gleichmäßige Schichtdicke zu achten.

### [Zusammenfassung]

Die Entwicklung betrifft eine Beschichtung von Glas mit thermochromen Vanadiumdioxid. Die Färbung des Vanadiumdioxids wird durch eine Dotierung mit Erdalkalielementen z.B. Ca, Sr, Ba von bronzen nach neutral (farblos) verschoben. Gleichzeitig bleibt der thermochrome Effekt bestehen.

## Patentansprüche

1. Thermochrome Schicht für Glas (12), die eine Vanadiumdioxidschicht (16) umfasst, **dadurch gekennzeichnet, dass** die Vanadiumdioxidschicht aus Vanadiumdioxid besteht und eine Dotierung mit den Erdalkalimetallen Calcium, Barium, Strontium einzeln oder in Kombination umfasst.

2. Thermochrome Schicht nach Anspruch 1, **dadurch gekennzeichnet, dass** die Vanadiumdioxidschicht (16) eine zusätzliche Dotierung mit Wolfram und/oder Fluor aufweist.

3. Thermochrome Schicht nach einem der Ansprüche 1 oder 2, **dadurch gekennzeichnet, dass** die Vanadiumdioxidschicht (16) zusätzlich eine Kristallkeimschicht (14) und / oder eine Abdeckschicht (18) aufweist.

4. Thermochrome Schicht nach einem der Ansprüche 1 bis 3, **dadurch gekennzeichnet, dass** die Kristallkeimschicht (14) Verbindungen wie Titandioxid, Siliziumoxid umfasst.

5. Thermochrome Schicht nach einem der Ansprüche 1 bis 4, **dadurch gekennzeichnet, dass** die Abdeckschicht (18) Verbindungen wie Aluminiumoxinitrid, Zinkoxisulfid, Zinkoxid und Zinksulfid umfasst.

6. Verfahren zur Herstellung einer thermochromen Schicht mit einer Vanadiumdioxidschicht (16) nach Anspruch 1, **dadurch gekennzeichnet, dass** die Vanadiumdioxidschicht (16) mit den Erdalkalimetallen Calcium, Barium, Strontium einzeln oder in Kombination dotiert wird.

7. Verfahren zur Herstellung einer thermochromen Schicht nach Anspruch 6, **dadurch gekennzeichnet, dass** die Beschichtung eines Trägers mit den einzelnen Schichten, einer Kristallkeimschicht (14), der dotierten Vanadiumdioxidschicht (16), einer Abdeckschicht (18), durch Hochfrequenz- bzw. Radiofrequenz-Kathodenzerstäubungsverfahren oder DC-Kathodenzerstäubungsverfahren erfolgt.

8. Verwendung einer thermochromen Schicht nach Anspruch 1 für Glas, Solarzellen oder Solarkollektoren.

9. Verwendung einer thermochromen Schicht nach Anspruch 8 für Glas, nämlich für Fensterglas, Glasrohre oder Trinkgläser.

10. Verwendung einer thermochromen Schicht nach Anspruch 8 für Solarzellen, nämlich bei der Photovoltaik.

11. Verwendung einer thermochromen Schicht nach Anspruch 8 für Solarkollektoren, nämlich bei der Warmwasseraufbereitung.

## Claims

1. Thermochromic coating for glass (12) that contains a vanadium dioxide coating (16), is **characterized by** the vanadium dioxide coating consisting of vanadium oxide doped with the alkaline earth metals calcium, barium and strontium individually or in combination.

2. Thermochromic layer according to claim 1, **characterized by** the vanadium dioxide coating (16) that contains an additional dopant with tungsten and/or fluorine.

3. Thermochromic layer according to claim 1 or 2, **characterized by** the vanadium dioxide coating (16) that also contains a seed crystal layer (14) and/or a covering layer (18).

4. Thermochromic layer according to any one of claims 1 to 3, **characterized by** the seed crystal layer (14) containing compounds such as titanium dioxide or silicon oxide.

5. Thermochromic layer according to any one of claims 1 to 4, **characterized by** the covering layer (18) containing compounds such as aluminium oxynitride, zinc oxysulfide, zinc oxide and zinc sulfide.

6. A process for the preparation of a thermochromic layer with a vanadium dioxide coating (16) according to claim 1, **characterized by** the vanadium dioxide coating (16) being doped with the alkaline earth metals calcium, barium and strontium individually or in combination.

7. A process for the preparation of a thermochromic layer according to claim 6, **characterized by** the coating of a carrier with the individual layers, with a seed layer (14), with the doped vanadium dioxide coating (16), and with a cover layer (18), being made by highfrequency or radio-frequency sputtering or DC sputtering.

8. Use of a thermochromic layer according to claim 1 for glass, solar cells or solar collectors.

9. Use of a thermochromic layer according to claim 8 for glass, particularly for window glass, glass tubes or drinking glasses.

10. Use of a thermochromic layer according to claim 8 for solar cells, particularly in the photovoltaic industry.

11. Use of a thermochromic layer according to claim 8 for solar collectors particularly for hot water processing.

## Revendications

1. Couche thermochromique pour verre (12), comprenant une couche de dioxyde de vanadium (16), **caractérisée en ce que** la couche de dioxyde de vanadium consiste en dioxyde de vanadium et qu'elle comprend un dopage avec les métaux alcalinoterreux calcium, baryum, strontium, séparément ou en combinaison.

2. Couche thermochromique selon la revendication 1, **caractérisée en ce que** la couche de dioxyde de vanadium (16) comprend un dopage supplémentaire au tungstène et/ou fluor.

3. Couche thermochromique selon une des revendications 1 ou 2, **caractérisée en ce que** la couche de dioxyde de vanadium (16) comprend en plus une couche de germe cristallin (14) et / ou une couche de couverture (18).

4. Couche thermochromique selon une des revendications 1 à 3, **caractérisée en ce que** la couche de germe cristallin (14) comprend des composés chimiques comme du dioxyde de titane, de l'oxyde de silicium.

5. Couche thermochromique selon une des revendications 1 à 4, **caractérisée en ce que** la couche de couverture (18) comprend des composés chimiques comme de l'oxynitrure d'aluminium, de l'oxysulfure de zinc, de l'oxyde de zinc et du sulfure de zinc.

6. Procédé pour la fabrication d'une couche thermochromique comprenant une couche de dioxyde de vanadium (16) selon revendication 1, **caractérisé en ce que** la couche de dioxyde de vanadium (16) comprend un dopage avec les métaux alcalinoterreux calcium, baryum, strontium, séparément ou en combinaison.

7. Procédé pour la fabrication d'une couche thermochromique selon la revendication 6, **caractérisé en ce que** le revêtement d'un support avec les différentes couches, d'une couche de germe cristallin (14), d'une couche de dioxyde de vanadium dopée (16), d'une couche de couverture (18) est réalisé par un procédé de pulvérisation cathodique à haute fréquence ou à radiofréquence ou un procédé de pulvérisation cathodique à courant continu.

8. Utilisation d'une couche thermochromique selon la revendication 1 pour du verre, des cellules solaires ou des capteurs solaires.

9. Utilisation d'une couche thermochromique selon la revendication 8 pour du verre, en particulier pour des vitrages, tubes en verre et verres à boisson.

10. Utilisation d'une couche thermochromique selon la revendication 8 pour des cellules solaires, en particulier des cellules photovoltaïques.

11. Utilisation d'une couche thermochromique selon la revendication 8 pour des capteurs solaires, en particulier pour la production d'eau chaude.
